(19) **Europäisches Patentamt**

**European Patent Office**

**Office européen des brevets**

(11) **EP 0 219 846 B1**

(12) **EUROPEAN PATENT SPECIFICATION**

(45) Date of publication and mention
of the grant of the patent:
**24.05.2000 Bulletin 2000/21**

(51) Int. Cl.⁷: **H03K 3/037**

(21) Application number: **86114529.0**

(22) Date of filing: **21.10.1986**

(54) **Latch circuit tolerant of undefined control signals**

Gegenüber undefinierten Steuersignalen tolerante Verriegelungsschaltung

Circuit de verrouillage tolérant des signaux de commande indéfinis

(84) Designated Contracting States:
**DE GB NL**

(30) Priority: **21.10.1985 JP 23571585**

(43) Date of publication of application:
**29.04.1987 Bulletin 1987/18**

(73) Proprietor:
**MITSUBISHI DENKI KABUSHIKI KAISHA
Tokyo (JP)**

(72) Inventors:
• **Sasada, Tatsuyoshi
Mitsubishi Denki K.K.
Itami-shi Hyogo (JP)**

• **Okitaka, Takenori
Mitsubishi Denki K.K.
Itami-shi Hyogo (JP)**

(74) Representative:
**Lehn, Werner, Dipl.-Ing. et al
Hoffmann Eitle,
Patent- und Rechtsanwälte,
Postfach 81 04 20
81904 München (DE)**

(56) References cited:
**WO-A-84/03012**

• **PATENT ABSTRACTS OF JAPAN, vol. 6, no. 145
(P-132)(1023), 4th August 1982:& JP-A-57 64 394**

## Description

This invention relates to a latch circuit used for a semiconductor integrated circuit device or the like.

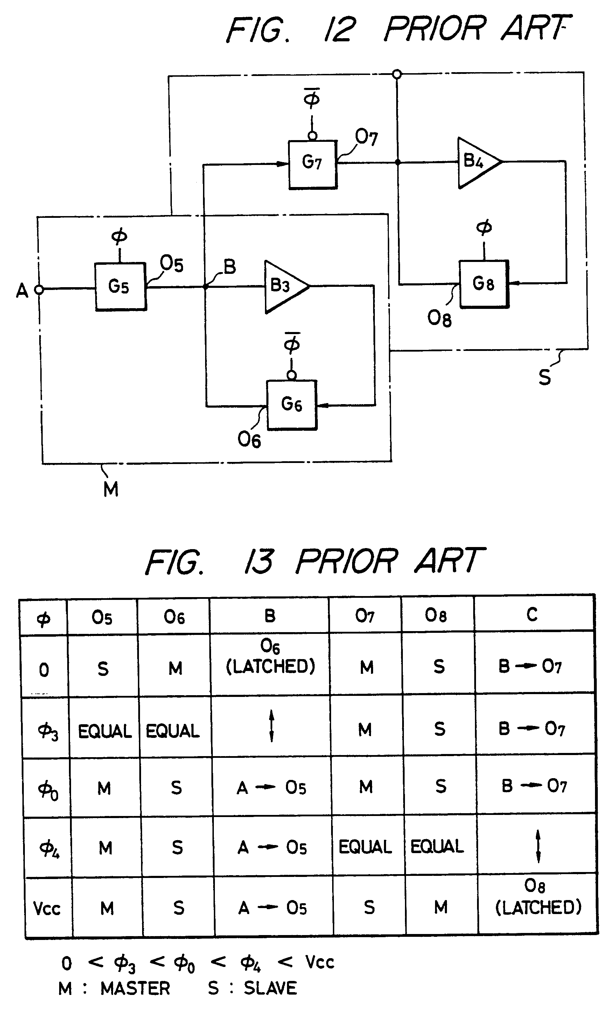

Figure 12 shows a conventional master/slave latch circuit belonging to the prior art. In Fig. 12 is shown an input A to a master latch circuit M. An input B to a slave latch circuit S is the output of the master latch circuit M. Also shown are an output C of the slave latch circuit S and a control signal $\phi$. A master input gate $G_5$ and a slave latching gate $G_8$ have enable state and disable states controlled by a control signal $\phi$ and have respective outputs $O_5$ and $O_6$. A master latching gate $G_6$ and a slave input gate $G_7$ have their enable states and disable states controlled by a control signal $\bar{\phi}$ and have respective outputs $O_7$ and $O_8$. The control signal $\bar{\phi}$ is the complement of the control signal $\phi$. The master latch circuit M contains a buffer $B_3$ and in the slave latch circuit S contains a buffer $B_4$.

Figure 13 is a table indicating the states of the gates $G_5$ through $G_8$ and of the latch circuit outputs B and C with the states of the control signal $\phi$.

The operation of the conventional master/slave latch circuit will be described.

When the master input gate $G_5$ and the slave latching gate $G_8$ are enabled by the control signal $\phi$, the gates $G_6$ and $G_7$ are disabled. As a result, the signal of the input A is applied to the output $O_5$ of the gate $G_5$. Simultaneously, in the slave latch circuit S the signal of the output C existing before the change of the control signal $\phi$ is latched by the gate $G_8$ and the buffer $B_4$. When the control signal $\phi$ is inverted, the gates $G_5$ and $G_8$ are disabled while the gates $G_6$ and $G_7$ are placed in an enabled state. Under this condition, in the master latch circuit M, the signal of the output B existing before the control signal $\phi$ is inverted is latched by the gate $G_6$ and the buffer $B_3$. At the same time, the signal of the output B latched by the master latch circuit M is transmitted through the gate $G_7$ in the slave latch circuit S and thus transmitted to the output C.

The conventional master/slave latch circuit suffers from a difficulty that, when the potential of the control signal $\phi$ becomes unstable between the "H (high)" potential and the "L (low)" potential (for instance the potential of the control signal $\phi$ changes slowly from "L" to "H"), the signal of the input A read into the master latch circuit M is directly transmitted to the output C of the slave latch circuit S. The signal provided at the output B (described later) is determined by which one of the outputs of the master input gate $G_5$ and the slave latching gate $G_8$ has the smaller output impedance. Similarly, the signal provided at the output C is determined by which one of the outputs of the master latching gate $G_6$ and the slave input gate $G_7$ has the smaller output impedance. These output impedances are determined depending upon performances of transistors used therein.

On the other hand, in the conventional master/slave latch circuit, in order to decrease the delay time of signal transmission from the input A to the output B and from the input B to the output C, the input gate $G_5$ in the master latch circuit and the input gate $G_7$ in the slave latch circuit are made large in transistor size. Also, in order to reduce the chip size of the semiconductor integrated circuit device or the like the master latching gate $G_6$ and the slave latching gate $G_8$ are made small in transistor size. Accordingly, in the above-described case, when the potential of the control signal $\phi$ is $\phi_3$ (O $< \phi_3 < \phi_0$), the output impedance $Z_5$ of the master input gate $G_5$ becomes equal to the output impedance $Z_6$ of the master latching gate $G_6$. Furthermore, when the potential of the control signal $\phi$ is $\phi_4$ ($\phi_0 < \phi_4 < V_{cc}$), the output impedance $Z_7$ of the slave input gate $G_7$ becomes equal to the output impedance $Z_8$ of the slave latching gate $G_8$. Therefore, when $\phi_3 < \phi < \phi_4$, the output impedance $Z_5$ of the master input gate $G_5$ is lower than the output impedance $Z_6$ of the master latching gate $G_6$, and the output impedance $Z_7$ of the slave input gate $G_7$ is lower than the output impedance $Z_8$ of the slave latch-ing gate $G_8$. As a result of this, at the output B the output $O_5$ of the master input gate $G_5$ is provided as a "master" output while the output $O_6$ of the master latching gate $G_6$ is provided as a "slave" output. Also, at the output C the output $O_7$ of the gate slave input $G_7$ is provided as a "master" output while the output $O_8$ of the slave latching gate $G_8$ is provided as a "slave" output. That is, both of the outputs $O_5$ and $O_7$ from the input gates $G_5$ and $G_7$ are provided as "master " outputs, and the signal of the input A read into the master latch circuit M is transmitted directly to the slave latch circuit output C with the result that the function of the master/slave latch circuit is not correctly performed. That is, the master/slave latch circuit operates erroneously.

In WO-A-8 403 012 a further master/slave latching circuit is described which also consists of a master latch circuit having a reading gate and a latching gate and a slave latch circuit with the same components. The operation of the circuit is controlled by a control signal applied to the gates. The operation of the known latching circuit is similar to that of the circuit shown in Fig. 12.

Accordingly, an object of this invention is to eliminate the above-described difficulties accompanying a conventional master/slave latch circuit.

More specifically, an object of the invention is to provide a master/slave latch circuit in which its original master/slave latch function is correctly performed and the erroneous operation is prevented.

Reference is also made to JP-A-57 64394 which discloses master-and-slave circuits, each having an input data receiving gate, a logic circuit in series and a positive feedback gate. Errors in the high level data in the memory circuits resulting from a time delay in appli-cation of clock pulses $\bar{\phi}$ and $\phi$ to the slave circuit with respect to application of the clock pulses $\phi$ and $\bar{\phi}$ to the master circuit are avoided by connecting a resistance in series to the input side of each input data receiving gate.

The objects of the present invention are solved by a latch circuit including:

a master latch circuit (M) including a first reading gate ($G_1$) for receiving an input signal (A) and for providing an output signal ($0_1$) to a first connection point and a first latching gate ($G_2$) for receiving an input derived from said first connection point and for providing an output ($0_2$) to said first connection point;

first means for controlling said master latch circuit (M) by a control signal ($\phi$) alternately to enable said first reading gate ($G_1$) and disable said first latching gate ($G_2$) and to disable said first reading gate ($G_1$) and enable said first latching gate ($G_2$) to thereby enable a first latching output ($O_2$) at said first connection point;

a slave latch circuit (S) including a second reading gate ($G_3$) for receiving an input from said first connection point and for providing an output signal ($0_3$) to a second connection point and a second latching gate ($G_4$) for receiving an input derived from said second connection point and for providing an output signal ($0_4$) to said second connection point;

second means for controlling said slave latch circuit (S) by said control signal ($\phi$) alternately to enable said second latching gate ($G_4$) and disable said second reading gate ($G_3$) and to disable said second latching gate ($G_4$) and enable said second reading gate ($G_3$) to thereby enable a second latched output ($0_4$) at said second connection point; characterized in that the output impedances ($Z_1$ to $Z_4$) of said gates ($G_1$ to $G_4$) satisfy the following condition when the magnitude of the voltage of said control signal ($\phi$) lies within a predetermined range, $\phi, < \phi < \phi_2$, of which the lower end value ($\phi_1$) is the control signal voltage at which the output impedances ($Z_3$, $Z_4$) of the second reading and latching gates ($G_3$, $G_4$) transiently become equal and the upper end value ($\phi_2$) is the control signal voltage at which the output impedances ($Z_1$, $Z_2$) of the first reading and latching gates ($G_1$, $G_2$) transiently become equal, said condition being:

$$Z_1 > Z_2 \text{ and}$$

$Z_3 > Z_4$, whereby for any voltage value of said control signal ($\phi$), said first reading gate ($G_1$) provides an output signal ($0_1$) to said first connection point at times other than when said second reading gate ($G_3$) provides said output signal ($0_3$) to said second connection point.

A master/slave latch circuit according to the invention is so designed that, irrespective of the magnitude of voltage of a gate control signal, the output of a reading gate in the master latch circuit and the output of a reading gate in the slave latch circuit are not provided as "master" outputs simultaneously.

In the master/slave latch of the invention, there is provided a means for preventing, irrespective of the value of voltage of the gate control signal, the simultaneous output of the input gate in the master latch circuit and the output of the input gate in the slave latch circuit. Thus, the outputting of the input signal of the master latch circuit directly from the slave latch circuit is prevented.

Fig. 1 is a circuit diagram showing a master/slave latch circuit which is a first embodiment of this invention.
Fig. 2 is a diagram indicating the states of various gates with the states of a control signal $\phi$.
Fig. 3 is a diagram showing equivalent circuits of the master latch circuit and the slave latch circuit with $\phi = \bar{\phi} = \phi_0$.
Figs. 4, 5, 7, 8, 10, and 11 are circuit diagrams showing master/slave latch circuits which are other embodiments of the invention.
Fig. 6 is a diagram showing examples of clocked gates employed in the circuits of Figs. 7 and 8.
Fig. 9 is a diagram showing examples of transmission gates used in the circuits of Figs. 10 and 11.
Fig. 12 is a circuit diagram showing a conventional ordinary master/slave latch circuit.
Fig. 13 is a diagram indicating the states of various gates with the states of a control signal $\phi$.

In these figures, like parts are designated by like reference numerals or characters.

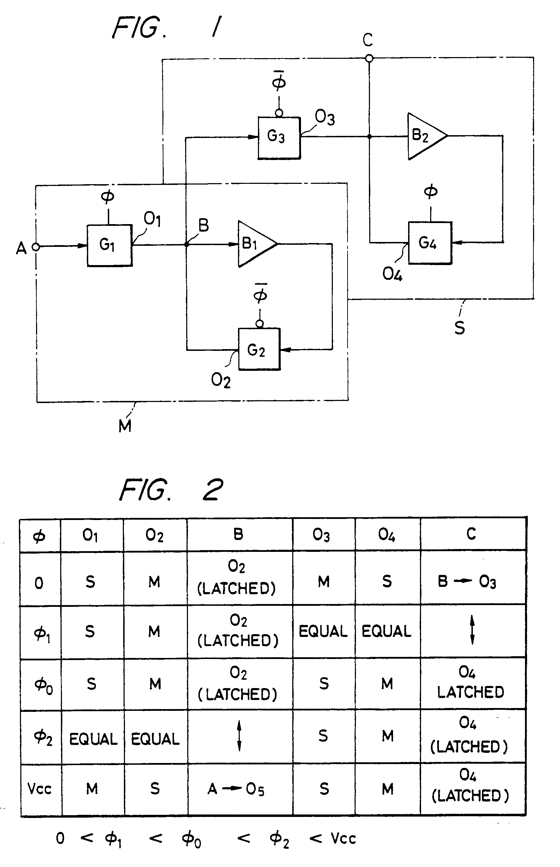

A first embodiment of this invention will be described with reference to Fig. 1. The outward form of this circuit is the same as that of Fig. 12, although the elements have been renumbered. Most importantly, the output impedances of the gates are restricted.

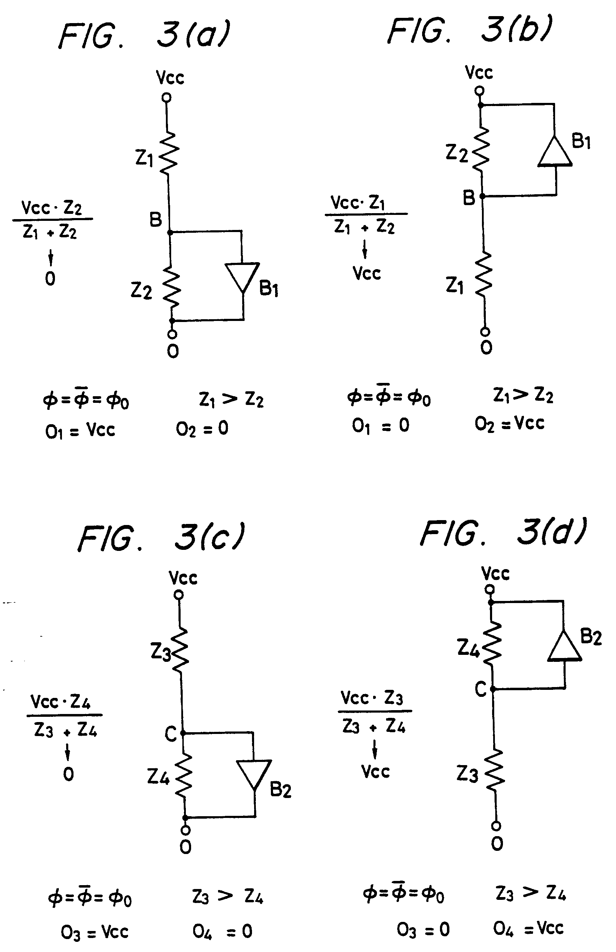

However, the associated logic table is different. Fig. 2 indicates the states of outputs $O_1$ through $O_4$ of gates $G_1$ through $G_4$ and the latch circuit outputs B and C as a function of the voltages of the control signal $\phi$. Figure 3 shows equivalent circuits of the master and the slave latch circuits in the case when $\phi = \bar{\phi} = \phi_0$, showing the variation in potential of the output B. In Fig. 3, reference characters $Z_1$ through $Z_4$ designate respectively the output impedances of the master input gate $G_1$, the master latching gate $G_2$, the slave input gate $G_3$ and the slave latching gate $G_4$. It is required that $Z_1$ is equal to or greater than $Z_2$ and $Z_3$ is greater than $Z_4$ and these output impedances are selected from the range of 100 ohms to 1,000 ohms so as to meet the characteristics of transistors used therein. $B_1$ and $B_2$ respectively represent the buffers in the master latch circuit and the slave latch circuit.

The enabled and disabled states of the gates $G_1$ and $G_4$ are controlled by the control signal $\phi$ while the enabled and disabled states of the gates $G_2$ and $G_3$ are controlled by the complemented control signal $\bar{\phi}$. When the gates $G_1$ and $G_4$ are in the enabled state and the gate $G_2$ and $G_3$ are in the disabled state, in the master latch circuit the signal of the input A is transmitted to the output $O_1$ of the master input gate $G_1$ while in the slave latch circuit the signal of the output C provided before the change of the control signal $\phi$ is latched by the slave latching gate $G_4$ and the buffer $B_2$. Upon the inversion of the control signal $\phi$, the gates $G_1$ and $G_4$ are disabled while the gates $G_2$ and $G_3$ are enabled. In this operation, in the master latch circuit, the signal of the output B provided before inversion of the control signal $\phi$ is latched by the master latching gate $G_2$ and the buffer $B_1$, while in the slave latch circuit the signal of the output B thus latched is read by the slave input gate $G_3$ and transmitted to the output C.

In the above-described embodiment, as shown in Fig. 3, when $\phi = \bar{\phi} = \phi_0$, in the master latch circuit, the output impedance $Z_2$ of the latching gate $G_2$ is less than output the impedance $Z_1$ of the input gate $G_1$. Therefore, at the master output B, the potential of the output $O_2$ of the master latching gate $G_2$ is provided as a "master" potential while the potential of the output $O_1$ of the master input gate $G_1$ is provided as a "slave" potential (cf. the parts (a) and (b) of Fig. 3). In the slave latch circuit, the output impedance $Z_4$ of the latching gate $G_4$ is less than the output impedance $Z_3$ of the input gate $G_3$. Therefore, at the slave output C, the potential of the output $O_4$ of the slave latching gate $G_4$ is provided as a "master" potential while the potential of the output $O_3$ of the slave input gate $G_3$ is provided as a "slave" potential (cf. parts (c) and (d) of Fig. 3).

Accordingly, in the above-described embodiment, as shown in Fig. 2, when the potential of the control signal $\phi$ is $\phi_1$ ($O^- < \phi_1 < \phi_0$), the output impedance $Z_3$ of the slave input gate $G_3$ becomes equal to the output impedance $Z_4$ of the slave latching gate $G_4$. Also, when the potential of the control signal $\phi$ is $\phi_2$ ($\phi_0 < \phi_2 < V_{cc}$), the output impedance $Z_1$ of the master input gate $G_1$ becomes equal to the output impedance $Z_2$ of the master input gate $G_2$. Therefore, at the output B, when $0 \leqq \phi < \phi_2$, the output $O_2$ of the master latching gate $G_2$ is provided as a "master" output while the output $O_1$ of the gate $G_1$ is provided as a "slave" output. Also, when $\phi_2 < \phi \leqq V_{cc}$, the output $O_1$ of the master input gate $G_1$ is provided provided as a "master" output while the output $O_2$ of the master latching gate $G_2$ is provided as a "slave" output. And at the output C, when $O \leqq \phi < \phi_1$, the output $O_3$ of the slave input gate $G_3$ is provided as a "master" output while the output $O_4$ of the slave latching gate $G_4$ is provided as a "slave" output. Also, when $\phi_1 < \phi \leqq V_{cc}$ the output $O_4$ of the slave latching gate $G_4$ is provided as a "master" output while the output $O_3$ of the slave input gate $G_3$ is provided as a "slave" output. Therefore, there is no case in which both of the outputs $O_1$ and $O_3$ are provided as "master" outputs. That is, the difficulty that the signal of the input A read by the master latch circuit is transmitted directly to the slave latch circuit output C will never occur. Thus, the above described master/slave latch circuit will never operate erroneously.

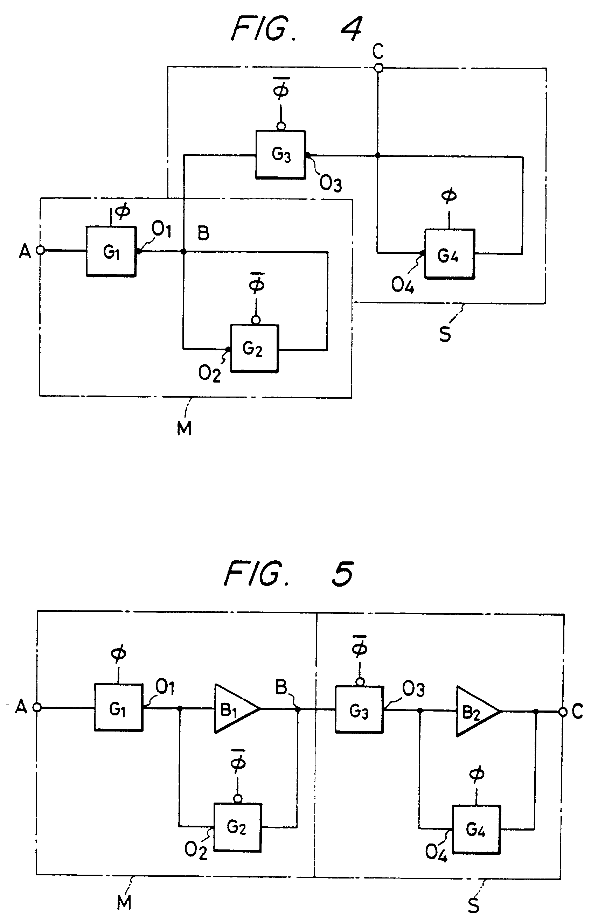

In the above-described embodiment, the buffers $B_1$ and $B_2$ are employed. However, in the case where the output of the gates $G_1$ through $G_4$ are sufficiently large, a circuit as shown in Fig. 4 in which the buffers $B_1$ and $B_2$ are not employed may be used with the same effect as the above-described embodiment.

In the above-described first embodiment, the output B of the master latch circuit is the connecting point of the output $O_1$ of the master input gate $G_1$ and the output $O_2$ of the master latching gate $G_2$. Also, the output C of the slave latch circuit S is the connecting point of the output $O_3$ of the slave input gate $G_3$ and the output $O_4$ of the slave latching gate $G_4$. However, the circuit may be so modified that, as shown in Fig. 5, the input of the master latching gate $G_2$ is the output B of the master latch circuit M, and the input of the slave latching gate $G_4$ is the output C of the slave latch circuit S.

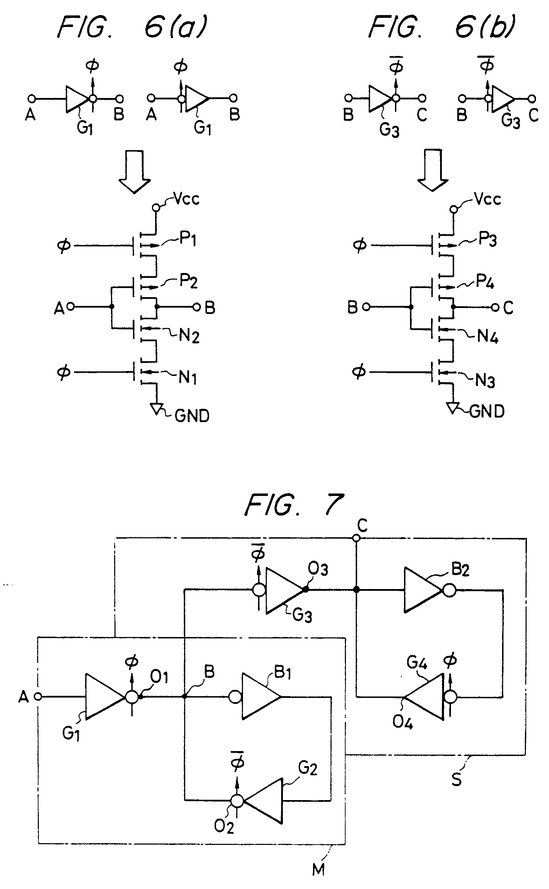

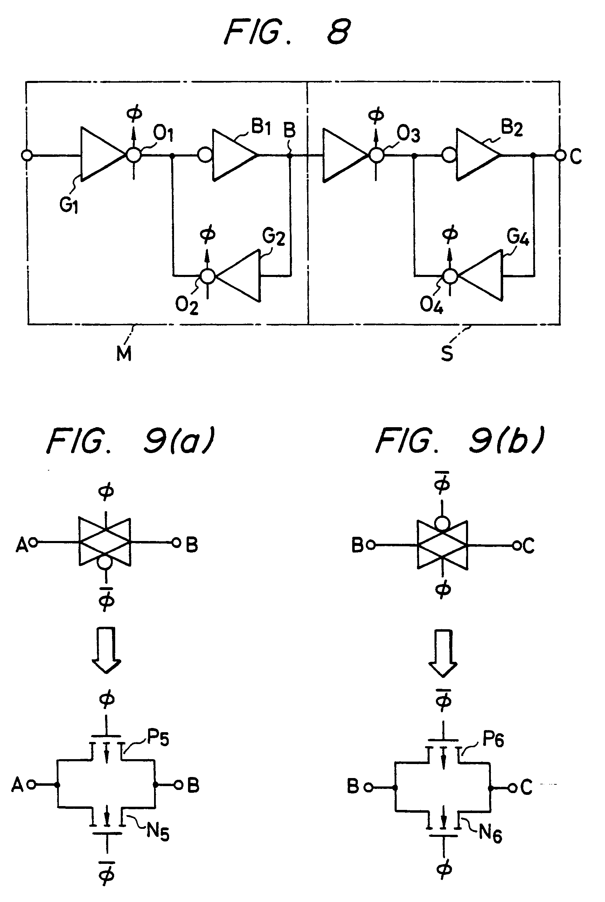

The first embodiment has been described with reference to the ordinary master/slave latch circuit. However, it may be modified as follows. The gates are replaced by clocked gates as shown in Figs. 6(a) and 6(b) to form a circuit as shown in Fig. 7 or 8, and the output impedance $Z_1$ through $Z_4$ of the clocked gates $G_1$ through $G_4$ are determined similarly as in the case of the above-described embodiment. The modification can provide the same effect as the above-described embodiment.

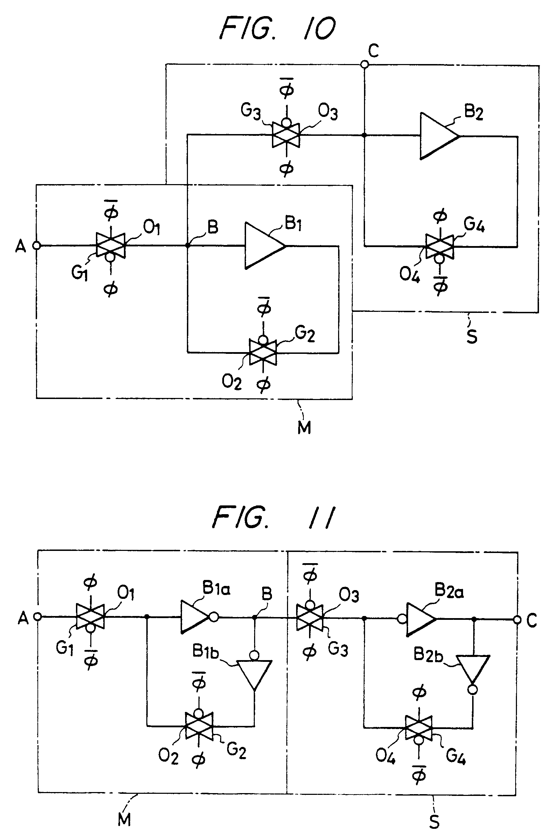

Furthermore, transmission gates as shown in the Figs. 9(a) and 9(b) may be employed to form a circuit as shown in Fig. 10 or 11, and the output impedance $Z_1$ through $Z_4$ of the transmission gates $G_1$ through $G_4$ are determined similarly as in the case of the above-described embodiment. This modification also can provide the same effect as the above-described embodiment.

In Figs. 6 and 9, reference characters $P_1$ through $P_6$ designate P-channel MOS transistors, and $N_1$ through $N_6$ N-channel MOS transistors.

As is apparent from the above description, the master/slave latch circuit according to the invention is so designed that, when the voltage of the control signal $\phi$ or $\bar{\phi}$ changes slowly in the range of 0V to $V_{cc}$, the output of the reading gate in the master latch circuit and the output of the reading gate in the slave latch circuit may not be provided as "master" outputs simultaneously. Therefore, the master/slave latch circuit of the invention is free from the erroneous operation that the signal of the input A is transmitted through the output B of the master latch circuit directly to the slave latch circuit output C.

## Claims

1. A latch circuit including:

a master latch circuit (M) including a first reading gate ($G_1$) for receiving an input signal (A) and for providing an output signal ($0_1$) to a first connection point and a first latching gate ($G_2$) for receiving an input derived from said first connection point and for providing an output ($0_2$) to said first connection point;

first means for controlling said master latch circuit (M) by a control signal ($\phi$) alternately to enable said first reading gate ($G_1$) and disable said first latching gate ($G_2$) and to disable said first reading gate ($G_1$) and enable said first latching gate ($G_2$) to thereby enable a first latching output ($O_2$) at said first connection point;

a slave latch circuit (S) including a second reading gate ($G_3$) for receiving an input from said first connection point and for providing an output signal ($0_3$) to a second connection point and a second latching gate ($G_4$) for receiving an input derived from said second connection point and for providing an output signal ($0_4$) to said second connection point;

second means for controlling said slave latch circuit (S) by said control signal ($\phi$) alternately to enable said second latching gate ($G_4$) and disable said second reading gate ($G_3$) and to disable said second latching gate ($G_4$) and enable said second reading gate ($G_3$) to thereby enable a second latched output ($0_4$) at said second connection point; characterized in that the output impedances ($Z_1$ to $Z_4$) of said gates ($G_1$ to $G_4$) satisfy the following condition when the magnitude of the voltage of said control signal ($\phi$) lies within a predetermined range, $\phi < \phi < \phi_2$, of which the lower end value ($\phi_1$) is the control signal voltage at which the output impedances ($Z_3$, $Z_4$) of the second reading and latching gates ($G_3$, $G_4$) transiently become equal and the upper end value ($\phi_2$) is the control signal voltage at which the output impedances ($Z_1$, $Z_2$) of the first reading and latching gates ($G_1$, $G_2$) transiently become equal, said condition being:

$$Z_1 > Z_2 \text{ and } Z_3 > Z_4,$$

whereby for any voltage value of said control signal ($\phi$), said first reading gate ($G_1$) provides an output signal ($0_1$) to said first connection point at times other than when said second

reading gate ($G_3$) provides said output signal ($0_3$) to said second connection point.

2. A latch circuit as recited in claim 1, characterized in that when the magnitude of the voltage of the control signal ($\phi$) lies outside said range ($\phi_1 - \phi_2$), the output impedances satisfy either the condition:

$$Z_3 < Z_4, Z_1 > Z_2 \text{ ($\phi$ less than $\phi_1$)};$$

or the condition

$$Z_1 < Z_2, Z_3 > Z_4 \text{ ($\phi$ greater than $\phi_2$)}.$$

3. A latch circuit as recited in claim 1 or 2, characterized in that said first and second reading and latching cates ($G_1$ - $G_4$) are all clocked gates.

4. A latch circuit as recited in claim 1 or 2, characterized in that said first and second reading and latching gates ($G_1$ - $G_4$) are all transmission gates.

## Patentansprüche

1. Eine Latchschaltung, enthaltend:

eine Master-Latchschaltung (M) mit einem ersten Lesegatter ($G_1$) zum Empfangen eines Eingangssignals (A) und zum Bereitstellen eines Ausgangssignals ($O_1$) bei einem ersten Verbindungspunkt und einem ersten Latchgatter ($G_2$) zum Empfangen einer von dem ersten Verbindungspunkt abgeleiteten Eingangsgröße zum Bereitstellen einer Ausgangsgröße ($O_2$) bei dem ersten Verbindungspunkt;

eine erste Vorrichtung zum Steuern der Master-Latchschaltung (M) durch ein Steuersignal ($\phi$), um alternativ das erste Lesegatter ($G_1$) freizugeben und das erste Latchgate ($G_2$) zu sperren und das erste Lesegatter zu sperren und das erste Latchgatter ($G_2$) zu sperren, und um hierdurch eine erste Latch-Ausgangsgröße ($O_2$) bei dem ersten Verbindungspunkt freizugeben;

eine Slave-Latchschaltung (S) mit einem zweiten Lesegatter ($G_3$) zum Empfangen einer Eingangsgröße von dem ersten Verbindungspunkt und zum Bereitstellen eines Ausgangssignals ($O_3$) bei einem zweiten Verbindungspunkt und ein zweites Latchgatter ($G_4$) zum Empfangen einer von dem zweiten Verbindungspunkt abgeleiteten Eingangsgröße und zum Bereitstellen eines Ausgangssignals ($O_4$) bei dem zweiten Verbindungspunkt;

eine zweite Vorrichtung zum Steuern der Slave-Latchschaltung (S) durch das Steuersignal ($\phi$) alternativ zum Freigeben des zweiten Latchgatters ($G_4$) und zum Sperren des zweiten Lesegatters ($G_3$) und zum Sperren des zweiten Latchgatters ($G_4$) und zum Freigeben des zweiten Lesegatters ($G_3$), um hierdurch eine zweite gehaltene Ausgangsgröße ($O_4$) bei dem zweiten Verbindungspunkt freizugeben; dadurch gekennzeichnet, daß die Ausgangsimpedanzen ($Z_1$ bis $Z_4$) der Gatters ($G_1$ bis $G_4$) die folgende Bedingung dann erfüllen, wenn die Größe der Spannung des Steuersignals ($\phi$) in einem vorbestimmten Bereich, $\phi_1 < \phi > < \phi_2$, liegt, von dem der untere Endwert ($\phi_1$) die Steuersignalspannung ist, bei der die Ausgangsimpedanzen ($Z_3$, $Z_4$) der zweiten Lese- und Haltegatters ($G_3$, $G_4$) übergangsmäßig gleich werden, und der obere Endwert ($\phi_2$) die Steuersignalspannung ist, bei der die Ausgangsimpedanzen ($Z_1$, $Z_2$) der ersten Lese- und Haltegatters ($G_1$, $G_2$) transient gleich werden, derart, daß für die Bedingung gilt:

$$Z_1 > Z_2 \text{ und } Z_3 >$$

$Z_4$, wodurch für jeden Spannungswert des Steuersignals ($\phi$) das erste Lesegatter ($G_1$) ein Ausgangssignal ($O_1$) bei dem ersten Verbindungspunkt zu Zeiten anders als für den Fall bereitstellt, bei dem das zweite Lesegatter ($G_3$) das Ausgangssignal ($O_3$) bei dem zweiten Verbindungspunkt bereitstellt.

2. Latchschaltung nach Anspruch 1, dadurch gekennzeichnet, daß dann, wenn die Größe der Spannung des Steuersignals ($\phi$) außerhalb des Bereichs ($\phi_1$ - $\phi_2$) liegt, die Ausgangsimpedanzen entweder die Bedingung:

$$Z_3 < Z_4, Z_1 > Z_2 \text{ ($\phi$ kleiner als $\phi_1$)} ;$$

erfüllen, oder die Bedingung

$$Z_1 < Z_2, Z_3 > Z_4 \text{ ($\phi$ größer als $\phi_2$)}.$$

3. Latchschaltung nach Anspruch 1 oder 2, dadurch gekennzeichnet, daß die ersten und zweiten Lese- und Haltegatter ($G_1$ - $G_4$) sämtlich getaktete Gatters sind.

4. Latchschaltung nach Anspruch 1 oder 2, dadurch gekennzeichnet, daß die ersten und zweiten Lese- und Haltegatter ($G_1$ - $G_4$) sämtlich Übertragungsgatter sind.

**Revendications**

1. Circuit de verrouillage comprenant :

un circuit de verrouillage pilote (M) comprenant un premier portillon de lecture ($G_1$) destiné à recevoir un signal d'entrée (A) et à fournir un signal de sortie ($O_1$) à un premier point de connexion et un premier portillon de verrouillage ($G_2$) destiné à recevoir une entrée dérivée depuis ledit premier point de connexion et à fournir une sortie ($O_2$) audit premier point de connexion ;

des premiers moyens de commande dudit circuit de verrouillage pilote (M) par un signal de commande ($\phi$) destiné alternativement à mettre en service ledit premier portillon de lecture ($G_1$) et mettre hors service ledit premier portillon de verrouillage ($G_2$) et à mettre hors service ledit premier portillon de lecture ($G_1$) et à mettre en service ledit premier portillon de verrouillage ($G_2$) pour valider par ce moyen une première sortie de verrouillage ($O_2$) au niveau dudit premier point de connexion ;

un circuit de verrouillage asservi (S) comprenant un second portillon de lecture ($G_3$) destiné à recevoir une entrée provenant dudit premier point de connexion et à fournir un signal de sortie ($O_3$) à un second point de connexion et un second portillon de verrouillage ($G_4$) destiné à recevoir une entrée dérivée depuis ledit second point de connexion et à fournir un signal de sortie ($O_4$) audit second point de connexion ;

des seconds moyens de commande dudit circuit de verrouillage asservi (S) par ledit signal de commande ($\phi$) destiné alternativement à mettre en service ledit second portillon de verrouillage ($G_4$) et à mettre hors service ledit second portillon de lecture ($G_3$) et à mettre hors service ledit second portillon de verrouillage ($G_4$) et mettre en service ledit portillon de lecture ($G_3$) pour valider par ce moyen une seconde sortie verrouillée ($O_4$) au niveau dudit second point de connexion ;

caractérisé en ce que les impédances de sortie de (de $Z_1$ à $Z_4$) desdits portillons (de $G_1$ à $G_4$) satisfont à la condition suivante lorsque la grandeur de la tension dudit signal de commande ($\phi$) se trouve dans une plage prédéterminée $\phi_1 < \phi < \phi_2$, où la valeur extrême inférieure ($\phi_1$) est la tension du signal de commande à laquelle les impédances de sortie ($Z_3$, $Z_4$) des seconds portillons de lecture et de verrouillage ($G_3$, $G_4$) deviennent égales de façon transitoire et la valeur extrême supérieure ($\phi_2$) est la tension du signal de commande à laquelle les impédances de sortie ($Z_1$, $Z_2$) des premiers portillons de lecture et de verrouillage

$(G_1, G_2)$ deviennent égales de façon transitoire, ladite condition étant :

$$Z_1 > Z_2 \text{ et } Z_3 > Z_4,$$

grâce à laquelle pour toute valeur de tension dudit signal de commande ($\phi$), ledit premier portillon de lecture ($G_1$) fournit un signal de sortie ($O_1$) audit premier point de connexion à des moments autres que lorsque ledit second portillon de lecture ($G_3$) fournit ledit signal de sortie ($O_3$) audit second point de connexion.

2. Circuit de verrouillage selon la revendication 1, caractérisé en ce que lorsque la grandeur de la tension du signal de commande ($\phi$) se trouve en dehors de ladite plage ($\phi_1 - \phi_2$), les impédances de sortie satisfont soit à la condition :

$$Z_3 < Z_4, Z_1 > Z_2 \ (\phi \text{ inférieur à } \phi_1) ;$$

ou à la condition

$$Z_1 < Z_2, Z_3 > Z_4 \ (\phi \text{ plus grand que } \phi_2).$$

3. Circuit de verrouillage selon la revendication 1 ou 2, caractérisé en ce que lesdits premier et second portillons de lecture et de verrouillage (de $G_1$ à $G_4$) sont tous des portillons à horloge.

4. Circuit de verrouillage selon la revendication 1 ou 2, caractérisé en ce que lesdits premier et second portillons de lecture et de verrouillage (de $G_1$ à $G_4$) sont tous des portillons de transmission.

*FIG. 1*

*FIG. 2*

| $\phi$ | $O_1$ | $O_2$ | B | $O_3$ | $O_4$ | C |
|--------|-------|-------|---|-------|-------|---|
| 0 | S | M | $O_2$ (LATCHED) | M | S | B → $O_3$ |
| $\phi_1$ | S | M | $O_2$ (LATCHED) | EQUAL | EQUAL | ↕ |
| $\phi_0$ | S | M | $O_2$ (LATCHED) | S | M | $O_4$ LATCHED |
| $\phi_2$ | EQUAL | EQUAL | ↕ | S | M | $O_4$ (LATCHED) |
| Vcc | M | S | A → $O_5$ | S | M | $O_4$ (LATCHED) |

$$0 < \phi_1 < \phi_0 < \phi_2 < Vcc$$

# FIG. 3(a)

$$\frac{Vcc \cdot Z_2}{Z_1 + Z_2}$$

$$\downarrow$$

$$0$$

$$\phi = \overline{\phi} = \phi_0 \qquad Z_1 > Z_2$$

$$O_1 = Vcc \qquad O_2 = 0$$

# FIG. 3(b)

$$\frac{Vcc \cdot Z_1}{Z_1 + Z_2}$$

$$\downarrow$$

$$Vcc$$

$$\phi = \overline{\phi} = \phi_0 \qquad Z_1 > Z_2$$

$$O_1 = 0 \qquad O_2 = Vcc$$

# FIG. 3(c)

$$\frac{Vcc \cdot Z_4}{Z_3 + Z_4}$$

$$\downarrow$$

$$0$$

$$\phi = \overline{\phi} = \phi_0 \qquad Z_3 > Z_4$$

$$O_3 = Vcc \qquad O_4 = 0$$

# FIG. 3(d)

$$\frac{Vcc \cdot Z_3}{Z_3 + Z_4}$$

$$\downarrow$$

$$Vcc$$

$$\phi = \overline{\phi} = \phi_0 \qquad Z_3 > Z_4$$

$$O_3 = 0 \qquad O_4 = Vcc$$

*FIG. 4*

*FIG. 5*

## FIG. 6(a)

## FIG. 6(b)

## FIG. 7

# FIG. 8

# FIG. 9(a)

# FIG. 9(b)

## FIG. 10

## FIG. 11

## FIG. 12 PRIOR ART

## FIG. 13 PRIOR ART

| $\phi$ | $O_5$ | $O_6$ | B | $O_7$ | $O_8$ | C |
|---|---|---|---|---|---|---|
| 0 | S | M | $O_6$ (LATCHED) | M | S | B → $O_7$ |
| $\phi_3$ | EQUAL | EQUAL | ↕ | M | S | B → $O_7$ |
| $\phi_0$ | M | S | A → $O_5$ | M | S | B → $O_7$ |
| $\phi_4$ | M | S | A → $O_5$ | EQUAL | EQUAL | ↕ |
| Vcc | M | S | A → $O_5$ | S | M | $O_8$ (LATCHED) |

$$0 < \phi_3 < \phi_0 < \phi_4 < Vcc$$

M : MASTER     S : SLAVE